# EUROPÄISCHE PATENTANMELDUNG

(11) **EP 4 192 199 A1**
(43) Veröffentlichungstag der Anmeldung: **07.06.2023**
(21) Anmeldenummer: 21211555.4
(22) Anmeldetag: 01.12.2021
(51) Int. Cl.: H05K 1/02

(54) **LEITERPLATTE, SYSTEM, ENERGIEVERSORGUNGSVORRICHTUNG UND WERKZEUGMASCHINE**

(71) Anmelder: Hilti Aktiengesellschaft, 9494 Schaan (LI)
(72) Erfinder: Stanger, Robert, 87600 Kaufbeuren (DE); Hartmann, Markus, 87665 Mauerstetten (DE); Goyal, Varnim, 86899 Landsberg am Lech (DE); Hauser, Klaus, 86830 Schwabmünchen (DE); Holubarsch, Markus, 86899 Landsberg am Lech (DE); Brandner, Michael, 86899 Landsberg am Lech / Erpfting (DE); Lacher, Michael, 86830 Schwabmünchen (DE)
(74) Vertreter: Hilti Aktiengesellschaft Corporate Intellectual Property

(57) **Zusammenfassung**

Die vorliegende Erfindung betrifft eine Leiterplatte zur Verwendung in einer Energieversorgungsvorrichtung oder in einer Werkzeugmaschine, wobei die Leiterplatte mindestens eine äußere Lage und mindestens eine innere Lage aufweist, wobei mindestens eine der Lagen ganz oder teilweise aus Kupfer gebildet ist. In weiteren Aspekten betrifft die Erfindung ein System, sowie eine Werkzeugmaschine und eine Energieversorgungsvorrichtung, die jeweils eine solche Leiterplatte enthalten können.

## Beschreibung

Die vorliegende Erfindung betrifft eine Leiterplatte zur Verwendung in einer Energieversorgungsvorrichtung oder in einer Werkzeugmaschine, wobei die Leiterplatte mindestens eine äußere Lage und mindestens eine innere Lage aufweist, wobei mindestens eine der Lagen ganz oder teilweise aus Kupfer gebildet ist. In weiteren Aspekten betrifft die Erfindung ein System, sowie eine Werkzeugmaschine und eine Energieversorgungsvorrichtung, die jeweils eine solche Leiterplatte enthalten können.

### Hintergrund der Erfindung:

Die Erfindung ist auf dem technischen Gebiet der Leiterplatten (printed circuit boards, PCB) angesiedelt. Dort sind verschiedene Technologie-Ansätze bekannt, um elektrotechnische Bauteile, wie Leistungshalbleiter oder anderen Funktionsträger, auf einer Leiterplatte zu befestigen. Leiterplatten können als Bestandteil einer Leistungselektronik oder einer Steuerelektronik in Werkzeugmaschinen verwendet werden. Darüber hinaus können Leiterplatten als Bestandteil einer Leistungselektronik oder einer Steuerelektronik von Energieversorgungsvorrichtungen verwendet werden, mit denen die Werkzeugmaschine mit elektrischer Energie versorgt werden.

Es ist abzusehen, dass zukünftige Zelltechnologien, die die Grundlage für zukünftige Energieversorgungsvorrichtungen zur Versorgung von beispielsweise Werkzeugmaschinen mit elektrischer Energie sind, eine Abgabe von höheren Strömen ermöglichen. Insbesondere zeichnet sich eine erhöhte Konstant-Stromabgabe ab. Dadurch können immer leistungsfähigere Werkzeugmaschinen auf einen Akku- oder Batteriebetrieb umgerüstet werden, von denen die Fachwelt bisher angenommen hatte, dass sie einer Energieversorgung mit wiederaufladbaren Energieversorgungsvorrichtungen nicht zugänglich sind.

Eine technische Herausforderung bei der Bereitstellung von Leiterplatten, die in leistungsstarken Werkzeugmaschinen oder ihren Energieversorgungsvorrichtungen eingesetzt werden, besteht insbesondere darin, die Leiterplatten und ihre Komponenten ausreichend zu kühlen, da die hohen Ströme zu einer stärkeren Erwärmung der Leiterplatten und ihrer Komponenten führen können. Es ist ein Anliegen der vorliegenden Erfindung, die bei Betrieb der Werkzeugmaschine oder der Energieversorgungsvorrichtung entstehende Wärme möglichst gering zu halten, um das Beschädigungsrisiko für die Leiterplatte und ihre Komponenten, insbesondere ihrer Bestandteile aus Kunststoff, deutlich zu reduzieren.

Die Aufgabe, die der vorliegenden Erfindung zugrunde liegt, besteht darin, eine Leiterplatte anzugeben, die eine gegenüber konventionellen Leiterplatten erhöhte Stromtragfähigkeit aufweist, um den zukünftige Energieversorgungsvorrichtungen und den mit ihnen einhergehenden erhöhten Konstant-Stromabgaben gerecht zu werden. Die Fachwelt würde es insbesondere begrüßen, wenn die bereitzustellende Leiterplatte hochstromfähig ausgebildet ist, d.h. dazu eingerichtet ist, Konstant-Ströme von beispielsweise größer als 75 Ampère auszuhalten. Ein weiteres Anliegen der Erfindung besteht darin, eine Energieversorgungsvorrichtung und eine Werkzeugmaschine, sowie ein System daraus, anzugeben, in denen eine solche Leiterplatte enthalten sein kann. Insgesamt soll mit der Erfindung eine Stromtragfähigkeit der Elektronik von Energieversorgungsvorrichtung und/oder Werkzeugmaschine verbessert werden.

Die Aufgabe wird gelöst durch den Gegenstand der unabhängigen Ansprüche. Vorteilhafte Ausführungsformen zu dem Gegenstand der unabhängigen Ansprüche finden sich in den abhängigen Ansprüchen.

### Beschreibung der Erfindung:

Erfindungsgemäß ist eine Leiterplatte zur Verwendung in einer Energieversorgungsvorrichtung oder in einer Werkzeugmaschine vorgesehen, wobei die Leiterplatte mindestens eine äußere Lage und mindestens eine innere Lage aufweist, wobei mindestens eine der Lagen ganz oder teilweise aus Kupfer gebildet ist. Das bedeutet im Sinne der Erfindung bevorzugt, dass mindestens eine der Lagen mindestens einen Bereich aufweist, der Kupfer umfasst oder der aus Kupfer gebildet ist. Es ist im Sinne der Erfindung ganz besonders bevorzugt, dass die Leiterplatte äußere Lagen und innere Lagen aufweist, wobei die Lagen ganz oder teilweise aus Kupfer bestehen oder aus Kupfer gebildet sind. Es wird daher im Sinne der Erfindung auch von Kupferlagen gesprochen, wobei eine «Kupferlage» vorzugsweise mindestens einen Teilbereich umfasst, der Kupfer enthält oder aus Kupfer gebildet ist. Diese Teilbereiche werden im Sinne der Erfindung bevorzugt als «Kupferbereiche» bezeichnet. Tests haben gezeigt, dass mit der Erfindung der Widerstand der vorgeschlagenen Leiterplatte gegenüber konventionellen Leiterplatten, wie sie aus dem Stand der Technik bekannt sind, deutlich gesenkt werden kann. Insbesondere kann auch der Widerstand einer Leistungs- und/oder Steuerelektronik einer Energieversorgungsvorrichtung und/oder einer Werkzeugmaschine erheblich reduziert werden, wenn eine Leiterplatte gemäß der vorliegenden Erfindung in der Leistungs- und/oder Steuerelektronik verbaut ist. Aufgrund des geringeren Widerstands der vorgeschlagenen Leiterplatte wird unerwünschte Wärme gar nicht erst produziert und muss daher auch nicht aufwändig abgeführt werden. Dadurch kann der Kühlaufwand der Elektronik deutlich reduziert werden, wodurch Bauraum in der Energieversorgungsvorrichtung und/oder in der Werkzeugmaschine eingespart werden kann. Auf diese Weise können die Energieversorgungsvorrichtung und/oder die Werkzeugmaschine besonders kompakt und handlich ausgebildet werden, was insbesondere bei leistungsstarken Werkzeugmaschinen, die häufig unhandlich und schwer sind, ein wesentlicher Vorteil der Erfindung ist.

Die Leiterplatte gemäß der vorliegenden Erfindung weist eine überraschend hohe Stromtragfähigkeit auf, so dass die vorgeschlagene Leiterplatte optimal in Verbindung mit zukünftigen Energieversorgungsvorrichtungen mit hohen Abgabeströmen verwendet bzw. betrieben werden kann.

Es ist im Sinne der Erfindung bevorzugt, dass die Leiterplatte insgesamt mindestens vier Lagen umfasst, wobei mindestens eine der Lagen ganz oder teilweise aus Kupfer gebildet ist. Vorzugsweise weist mindestens eine der Lagen mindestens einen Bereich auf, der Kupfer umfasst oder der aus Kupfer gebildet ist. Es ist im Sinne der Erfindung bevorzugt, dass die mindestens eine äußere Lage eine Stärke von größer oder gleich 70 µm aufweist, während die mindestens eine innere Lage eine Stärke von kleiner oder gleich 70 µm aufweist. Die Leiterplatte kann mindestens ein elektronisches Bauteil aufweisen. Es ist im Sinne der Erfindung ganz besonders bevorzugt, dass es sich bei den elektronischen Bauteilen um Leistungshalbleiter handelt. Dabei handelt es sich im Sinne der Erfindung bevorzugt um Halbleiterbauelemente, die in der Leistungselektronik für das Steuern und Schalten hoher elektrischer Ströme und/oder Spannungen ausgelegt sind. Leistungshalbleiter können beispielsweise Konstant-Ströme von mehr als 40 Ampère, bevorzugt mehr als 60 Ampère und am meisten bevorzugt mehr als 80 Ampère, sowie bei Spannungen von mehr als 18 Volt leiten. Eine Leiterplatte ist im Sinne der Erfindung ein Träger für elektronische Bauteile. Sie dient der mechanischen Befestigung und elektrischen Verbindung von elektronischen Bauteilen und Funktionsträgern.

Die Leiterplatte umfasst vorzugsweise eine Reihe von Lagen auf, insbesondere innere Lagen und äußere Lagen, wie Vorderseite (top) und Rückseite (bottom) der Leiterplatte. Einzelne dieser Lagen können Kupfer umfassen oder aus Kupfer gebildet bzw. hergestellt sein («Kupferlagen»). Die Leiterplatten können aus unterschiedlichen Lagen zusammengesetzt sein. Beispielsweise können obere und untere Abschlusslagen vorgesehen sein, die die Leiterplatte nach oben bzw. nach unten gegenüber der Umwelt abschließen. Eine Leistungsführung durch die Leiterplatte erfolgt vorzugsweise in den Kupferlagen, die bevorzugt in einem äußeren Bereich der Leiterplatte angeordnet vorliegen. Der Begriff «äußere Lage» ist im Sinne der Erfindung bevorzugt so zu verstehen, dass es sich dabei nicht um eine Abschlußlage handelt, die den äußeren Abschluss der Leiterplatte in Richtung Umwelt bildet. Vorzugsweise bezeichnet der Begriff «äußere Lage» eine im Inneren der Leiterplatte angeordnete Kupferlage, die vorzugsweise nicht zentral innerhalb der Leiterplatte angeordnet ist, sondern eher in räumlicher Nähe zur Ober- und Unterseite der Leiterplatte. Mit anderen Worten kann ein Abstand der äußeren Lage zur Oberoder Unterseite der Leiterplatte kleiner sein als ein Abstand der äußeren Lage zur Mitte der Leiterplatte. Es ist im Sinne der Erfindung bevorzugt, dass diese vorzugsweise in den Außenbereichen der Leiterplatte angeordneten Kupferlagen im Vergleich zu anderen Komponenten bzw. Lagen der Leiterplatte dicker ausgebildet sind. Vorzugsweise können die äußeren, bevorzugt dickeren Kupferlagen stromführende Lagen sein. Der Begriff «stromführende Lage» ist vorzugsweise funktionell zu verstehen, wobei der Begriff «stromführende Lage» insbesondere eine Teilmenge der inneren und/oder der äußeren Lagen beschreibt, die dazu eingerichtet sind, Strom zu führen, insbesondere diejenigen großen Ströme in einer Größenordnung von größer als 40 A, bevorzugt größer als 60 A, am meisten bevorzugt größer als 80 A, die von der Energieversorgungsvorrichtung abgegeben werden. Es ist im Sinne der Erfindung ganz besonders bevorzugt, dass die äußeren Lagen der Leiterplatte, die vorzugsweise eine größere Stärke als die inneren Lagen aufweisen, die Funktion der Strom- oder Leistungsführung übernehmen, während die inneren, vorzugsweise dünneren Lagen beispielsweise zur Übertragung von Datenund/oder Kommunikationssignalen verwendet werden. Die nicht-stromführenden Lagen der Leiterplatte können beispielsweise für Kommunikationszwecke genutzt werden. Die nicht-stromführenden Lagen der Leiterplatte können beispielsweise auch als Kommunikations-Lagen bezeichnet werden. Der Begriff «Stärke einer Lage» wird im Sinne der Erfindung synonym verwendet zum Begriff «Dicke einer Lage». Darüber hinaus können im Inneren der Leiterplatten innere Funktionslagen vorgesehen sein, die ebenfalls aus Kupfer hergestellt werden, Kupfer umfassen oder einzelne kupferhaltige Bereiche aufweisen können. Solche Funktionslagen können beispielsweise für Kommunikationszwecke genutzt werden und dünner ausgebildet sein als die sog. stromführenden Lagen. Mit anderen Worten kann die Leiterplatte stromführende und nicht-stromführende Lagen aufweisen, wobei die stromführenden Lagen vorzugsweise eine größere Stärke aufweisen als die nicht-stromführenden Lagen. Vorzugsweise liegen die stromführenden Lagen in den Außenbereichen der Leiterplatte vor, d.h. in räumlicher Nähe zu der Oberund Unterseite der Leiterplatte, während die nicht-stromführenden, dünneren Lagen im zentralen Bereich der Leiterplatte angeordnet vorliegen.

Kupfer wird insbesondere wegen seiner guten elektrischen und/oder thermischen Leitfähigkeit als Material für die leitfähigen Bestandteile der Leiterplatte ausgewählt. Durch die Leistungsführung in der Leiterplatte kann eine Stärke des Kupfers bzw. der Kupferschichte in der Leiterplatte auf die Stromführung optimiert werden. Das heißt, dass die Kupferstärke in Abhängigkeit von der gewünschten Leistungsführung ausgewählt werden kann. Dafür können insbesondere dickere Kupferlagen vorgesehen sein. Zur Verbesserung der Stromtragfähigkeit können auch zwei oder mehrere Lagen elektrisch parallelgeschaltet werden. Es ist in diesem Zusammenhang insbesondere bevorzugt, die äußeren und/ oder inneren Lagen der Leiterplatten bzw. die Stärke ihrer Kupferplatten («Kupferstärke») entsprechend auszuwählen. Es ist im Sinne der Erfindung bevorzugt, dass die äußeren Lagen der Leiterplatte eine Stärke von größer oder gleich 70 µm aufweisen. Die inneren Lagen der Leiterplatte weisen bevorzugt eine Stärke von kleiner oder gleich 70 µm auf.

Zwischen den Funktionslagen und den Kupferlagen können Lagen aus einem isolierenden Grundmaterial der Leiterplatte angeordnet sein. Ein isolierendes Grundmaterial kann auch die Abschlusslagen der Leiterplatte bilden, die die Leiterplatte zur Umwelt hin abschließen. Zur Herstellung dieser isolierenden Lagen kann beispielsweise Harz und/oder Glasfaser verwendet werden, ohne darauf beschränkt zu sein.

Vorteilhafterweise kann die Leistungsführung insbesondere in den stärksten Kupferlagen der vorgeschlagenen Leiterplatte erfolgen. Bei diesen stärksten äußeren Kupferlagen der Leiterplatte kann eine Stärke der Kupferplatte beispielsweise bei 70 µm und mehr liegen. Tests haben gezeigt, dass bei erhöhtem Kupferbedarf weitere Lagen der Leiterplatte miteinander kombiniert werden können. Mit Hilfe der Erfindung kann die Kupferstärke einzelner Lagen beispielsweise verdoppelt werden, was sich positiv auf die Fähigkeit der Leiterplatte zur Leistungsführung auswirken kann. Dieser Vorteil kann insbesondere erreicht werden, ohne die notwendigen Abstände der Leiterbahnen bei der Herstellung der Leiterbahnstruktur zu erhöhen. Die Herstellung der Leiterplatten bzw. der Leiterbahnen umfasst häufig Ätz-Verfahrensschritte, wobei das Ätzen dazu führt, dass zwischen den einzelnen Leiterbahnen der Leiterplatte Mindestabstände nicht unterschritten werden können. Insofern war es überraschend, dass mit der Erfindung die Kupferstärke einzelner Lagen der Leiterplatte verdoppelt werden kann, ohne dass die notwendigen Abstände der Leiterbahnen bei der Herstellung der Leiterbahnstruktur erhöht werden müssen. Auf diese Weise kann eine bessere Strom- bzw. Leistungsführung erreicht werden, ohne die Herstellung der vorgeschlagenen Leiterplatte aufwändiger und/oder kostenintensiver zu gestalten. Es ist im Sinne der Erfindung bevorzugt, dass die Strom- bzw. Leistungsführung in den stromführenden Lagen der Leiterplatte erfolgt.

Es ist im Sinne der Erfindung bevorzugt, dass die Leiterplatte mindestens eine stromführende Lage aufweist, wobei eine Gesamtkupferstärke der mindestens einen stromführenden Lage in einem Bereich von größer als 130 µm liegt, bevorzugt in einem Bereich von größer als 150 µm und am meisten bevorzugt in einem Bereich von größer als 200 µm. Es ist im Sinne der Erfindung ganz besonders bevorzugt, dass die Leiterplatte mehr als eine stromführende Lage aufweist. Die Stärken bzw. Dicken dieser stromführenden Lagen können addiert werden, wobei die Summe der Dicken der einzelnen stromführenden Lagen vorzugsweise in einem Bereich von größer als 130 µm liegt, bevorzugt in einem Bereich von größer als 150 µm und am meisten bevorzugt in einem Bereich von größer als 200 µm. Auf diese Weise kann gewährleistet werden, dass die Leiterplatte ausreichend leitungsfähiges Material umfasst, um die von der Energieversorgungsvorrichtung abgegebenen Ströme aufnehmen und weiterleiten zu können, ohne dass es zu Beschädigungen an der Elektronik oder den Kunststoffteilen der Leiterplatte kommt. Es ist im Sinne der Erfindung insbesondere bevorzugt, dass die Stromführung in den inneren Lagen der Leiterplatte erfolgt. Beispielsweise kann die Leiterplatte zwei, drei, vier, fünf oder mehr stromführende Lagen aufweisen, die vorzugsweise im Inneren der Leiterplatte abgeordnet vorliegen und keine Außenlagen der Leiterplatte darstellen. Besonders bevorzugt sind herstellungsbedingt eine gerade Anzahl von Kupferlagen.

Es ist im Sinne der Erfindung bevorzugt, dass eine Gesamtkupferstärke aller Lagen in einem Bereich von größer als 210 µm liegt. Die Summe der Dicken aller Lagen der Leiterplatte wird im Sinne der Erfindung als «Gesamtkupferstärke» bezeichnet, selbst wenn ggf. nicht alle Lagen vollständig aus Kupfer bestehen, sondern ggf. nur teilweise aus Kupfer gebildet sind oder nur vereinzelte Kupferbereiche umfassen. Mit anderen Worten können die Dicken der inneren, der äußeren, der stromführenden und der nicht-stromführenden Lagen der Leiterplatte addiert werden, so dass die Gesamtkupferstärke der Leiterplatte erhalten wird. Eine Gesamtkupferstärke von mehr als 210 µm hat sich in Tests als besonders geeignet erwiesen, um in Verbindung mit besonders leistungsstarken Werkzeugmaschinen oder Energieversorgungsvorrichtungen, die hohe Konstant-Ströme in einem Bereich von größer als 20, 40, 60 oder 80 Ampère abgeben können, verwendet zu werden und den damit verbundenen erhöhten elektrischen Belastungen standzuhalten. Mithin kann mit der Erfindung eine besonders robuste und langlebige Leiterplatte bereitgestellt werden, die auch den längeren Lebenszeiten der zukünftigen Energieversorgungsvorrichtungen gerecht wird.

In einem zweiten Aspekt betrifft die Erfindung ein System umfassend eine Werkzeugmaschine und eine Energieversorgungsvorrichtung, wobei die Werkzeugmaschine und/oder die Energieversorgungsvorrichtung eine Leiterplatte gemäß der vorliegenden Erfindung aufweist bzw. aufweisen. Die für die Leiterplatte eingeführten Begriffe, Definitionen und technischen Vorteile gelten vorzugsweise für das System und die später vorgestellten Werkzeugmaschinen und Energieversorgungsvorrichtungen analog. Das System umfasst eine Werkzeugmaschine und eine Energieversorgungsvorrichtung, wobei entweder die Werkzeugmaschine oder die Energieversorgungsvorrichtung oder beide eine Leiterplatte gemäß der vorliegenden Erfindung aufweisen können. Mit anderen Worten kann mindestens eines der Systembestandteile «Werkzeugmaschine» und «Energieversorgungsvorrichtung» eine erfindungsgemäße Leiterplatte aufweisen. Mit dem vorgeschlagenen System kann durch die Verwendung der erfindungsgemäßen Leiterplatte eine besonders leistungsstarke Leistungs- und/oder Steuerelektronik für eine Werkzeugmaschine und/oder ihre Energieversorgungsvorrichtung bereitgestellt werden, wobei es sich bei der Werkzeugmaschine vorzugsweise um eine besonders leistungsstarke Werkzeugmaschine, wie ein Abbruchgerät, ein Schlagbohrhammer, ein Meißelgerät oder ein Kernbohrgerät handelt, während es sich bei der Energieversorgungsvorrichtung vorzugsweise um eine Energieversorgungsvorrichtung handelt, die dazu eingerichtet ist, Konstant-Ströme in einem Bereich von größer als 40 Ampère, bevorzugt größer als 60 Ampère am meisten bevorzugt größer als 80 Ampère an die Werkzeugmaschine abzugeben. Mithin kann mit der erfindungsgemäßen Leiterplatte ein zukunftstaugliches Werkzeugmaschinen-System bereitgestellt werden, mit dem darüber hinaus eine kompakte und handliche Werkzeugmaschine bzw. eine kompakte und handliche Energieversorgungsvorrichtung bereitgestellt werden kann, da der Kühlaufwand für die Leistungs- und/oder Steuerelektronik gering gehalten werden kann. Insbesondere kann mit der Erfindung ein System bereitgestellt werden, dass den hohen elektrischen Anforderungen, die sich aus möglichen zukünftigen Zelltechnologien ergeben, gerecht wird. Durch die Verwendung der erfindungsgemäßen Leiterplatte in der Werkzeugmaschine und/oder der Energieversorgungsvorrichtung können die hohen Konstant-Ströme, die von der Energieversorgungsvorrichtung abgegeben werden können, optimale geleitet bzw. geführt werden, ohne dass es zu Beschädigungen an den Geräten kommt. Insbesondere können auf diese Weise die Möglichkeiten, die die zukünftigen Zell- und/oder Batterietechnologien mit sich bringen, besonders gut ausgenutzt und für das System fruchtbar gemacht werden.

In einem weiteren Aspekt betrifft die Erfindung eine Werkzeugmaschine mit einer erfindungsgemäßen Leiterplatte, wobei es sich bei der Werkzeugmaschine vorzugsweise um eine besonders leistungsstarke Werkzeugmaschine, wie ein Abbruchgerät, ein Meißelgerät oder ein Kernbohrgerät handeln kann. Vorzugsweise kann die Werkzeugmaschine in einem erfindungsgemäßen System eingesetzt werden.

In noch einem weiteren Aspekt betrifft die Erfindung eine Energieversorgungsvorrichtung mit einer erfindungsgemäßen Leiterplatte, wobei es sich bei der Energieversorgungsvorrichtung vorzugsweise um eine Energieversorgungsvorrichtung handelt, die dazu eingerichtet ist, Konstant-Ströme in einem Bereich von größer als 40 Ampère, bevorzugt größer als 60 Ampère am meisten bevorzugt größer als 80 Ampère an die Werkzeugmaschine abzugeben, wobei die vorgeschlagene Leiterplatte durch ihre Ausgestaltung und die Anordnung ihrer Lagen optimal an die Anforderungen der neue Batterietechnologien angepasst ist. Es ist im Sinne der Erfindung bevorzugt, dass die Energieversorgungsvorrichtung eine erfindungsgemäße Leiterplatte aufweist. Vorzugsweise kann die Energieversorgungsvorrichtung in einem erfindungsgemäßen System eingesetzt werden.

Es ist im Sinne der Erfindung bevorzugt, dass die Energieversorgungsvorrichtung mindestens einer Energiespeicherzelle umfasst, die im Sinne der Erfindung als «Zelle» bezeichnet wird. Die mindestens eine Zelle weist einen Innenwiderstand DCR_I von kleiner als 10 Milliohm (mOhm) auf. In bevorzugten Ausgestaltungen der Erfindung kann der Innenwiderstand DCR_I der mindestens einen Zelle kleiner als 8 Milliohm und bevorzugt kleiner 6 Milliohm sein. Dabei wird der Innenwiderstand DCR_I vorzugsweise nach der Norm IEC61960 gemessen. Der Innenwiderstand DCR_I stellt insbesondere den Widerstand einer Zelle der Energieversorgungsvorrichtung dar, wobei etwaige Komponenten oder Zubehörteile der Zelle keinen Beitrag zum Innenwiderstand DCR_I leisten. Ein geringer Innenwiderstand DCR_I ist von Vorteil, da dadurch unerwünschte Wärme, die abgeführt werden muss, überhaupt nicht entsteht. Der Innenwiderstand DCR_I ist insbesondere ein Gleichstrom-Widerstand, der im Inneren einer Zelle der vorgeschlagenen Energieversorgungsvorrichtung gemessen werden kann. Selbstverständlich kann der Innenwiderstand DCR_I auch Zwischenwerte, wie 6,02 Milliohm; 7,49 Milliohm; 8,33 Milliohm; 8,65 Milliohm oder 9,5 Milliohm, annehmen.

Es hat sich gezeigt, dass mit dem Innenwiderstand DCR_I der mindestens einen Zelle von kleiner als 10 Milliohm eine Energieversorgungsvorrichtung bereitgestellt werden kann, die besonders gute thermische Eigenschaften in dem Sinne aufweist, dass sie besonders gut bei niedrigen Temperaturen betrieben werden kann, wobei der Kühlaufwand überraschend gering gehalten werden kann. Insbesondere ist eine Energieversorgungsvorrichtung mit einem Zell-Innenwiderstand DCR_I von kleiner als 10 Milliohm besonders gut geeignet, um besonders leistungsstarke Werkzeugmaschinen mit elektrischer Energie zu versorgen. Solche Energieversorgungsvorrichtungen können somit einen wertvollen Beitrag dazu leisten, einen Einsatz von akkubetriebenen Werkzeugmaschinen auch in solchen Anwendungsgebieten zu ermöglichen, von denen die Fachwelt bisher davon ausgegangen war, dass diese Anwendungsgebiete akkubetriebenen Werkzeugmaschinen nicht zugänglich sind.

Vorteilhafterweise kann mit eine solchen Energieversorgungsvorrichtung eine Möglichkeit dafür geschaffen werden, eine batterie- oder akkubetriebene Werkzeugmaschine mit einer erfindungsgemäßen Energieversorgungsvorrichtung über einen langen Zeitraum mit einer hohen Abgabeleistung zu versorgen, ohne die umliegenden Kunststoffbauteile oder die Zellchemie innerhalb der Zellen der Energieversorgungsvorrichtung zu schädigen.

Es ist im Sinne der Erfindung bevorzugt, dass ein Verhältnis eines Widerstands der mindestens einen Zelle zu einer Oberfläche A der mindestens einen Zelle kleiner als 0,2 Milliohm/cm² ist, bevorzugt kleiner als 0,1 Milliohm/cm² und am meisten bevorzugt kleiner als 0,05 Milliohm/cm². Bei einer zylindrischen Zelle kann die Oberfläche der Zelle beispielsweise von der Außenfläche des Zylinders, sowie der Oberseite und der Unterseite der Zelle gebildet werden. Es kann darüber hinaus im Sinne der Erfindung bevorzugt sein, dass ein Verhältnis eines Widerstands der mindestens einen Zelle zu einem Volumen V der mindestens einen Zelle kleiner als 0,4 Milliohm/cm³ ist, bevorzugt kleiner als 0,3 Milliohm/cm³ und am meisten bevorzugt kleiner als 0,2 Milliohm/cm³. Der Fachmann kennt für übliche geometrische Formen, wie Quader, Würfel, Kugel oder dergleichen, die Formeln zur Berechnung der Oberfläche oder des Volumens eines solchen geometrischen Körpers. Der Begriff «Widerstand» bezeichnet im Sinne der Erfindung bevorzugt den Innenwiderstand DCR_I, der vorzugsweise nach der Norm IEC61960 gemessen werden kann. Vorzugsweise handelt es sich dabei um einen Gleichstrom-Widerstand.

Es ist im Sinne der Erfindung bevorzugt, dass die mindestens eine Zelle einen Erwärmungskoeffizienten von kleiner als 1,0 W/(Ah·A) aufweist, bevorzugt kleiner als 0,75 W/(Ah·A) und besonders bevorzugt von kleiner als 0,5 W/(Ah·A). Darüber hinaus kann die mindestens eine Zelle dazu ausgebildet sein, im Wesentlichen konstant einen Strom von größer als 1.000 Ampère/Liter abzugeben. Die Angabe des Entladestroms erfolgt in Bezug auf das Volumen der mindestens einen Zelle, wobei als Einheit für das Volumen die Raum-Maßeinheit «Liter» (I) verwendet wird. Die erfindungsgemäßen Zellen sind somit in der Lage, pro Liter Zellvolumen einen Entladestrom von im Wesentlichen konstant größer als 1.000 A abzugeben. Mit anderen Worten ist eine Zelle mit einem Volumen von 1 Liter in der Lage, einen im Wesentlichen konstanten Entladestrom von größer als 1.000 A abzugeben, wobei die mindestens eine Zelle darüber hinaus einen Erwärmungskoeffizienten von kleiner als 1,0 W/(Ah·A) aufweist. In bevorzugten Ausgestaltungen der Erfindung kann die mindestens eine Zelle der vorgeschlagenen Energieversorgungsvorrichtung einen Erwärmungskoeffizienten von kleiner als 0,75 W/(Ah·A), bevorzugt kleiner als 0,5 W/ (Ah·A) aufweisen. Die Einheit des Erwärmungskoeffizienten lautet Watt / (Ampèrestunden · Ampère). Selbstverständlich kann der Erwärmungskoeffizient auch Zwischenwerte, wie 0,56 W/(Ah.A); 0,723 W/(Ah.A) oder 0,925 W/(Ah.A) aufweisen.

Die Erfindung ermöglicht vorteilhafterweise die Bereitstellung einer Energieversorgungsvorrichtung mit mindestens einer Zelle, die eine verringerte Erwärmung aufweist und somit besonders gut für die Versorgung von Werkzeugmaschine geeignet ist, bei denen hohe Leistungen und hohe Ströme, vorzugsweise Konstant-Ströme, für den Betrieb erwünscht sind. Insbesondere kann mit der Erfindung eine Energieversorgungsvorrichtung für eine Werkzeugmaschine bereitgestellt werden, bei der die Wärme, die gegebenenfalls bei Betrieb der Werkzeugmaschine und bei Abgabe von elektrischer Energie an die Werkzeugmaschine entsteht, besonders einfach und unkompliziert abgeführt werden kann. Tests haben gezeigt, dass mit der Erfindung nicht nur vorhandene Wärme besser abgeführt werden kann. Vielmehr wird mit der Erfindung verhindert, dass Wärme entsteht bzw. die bei Betrieb der Werkzeugmaschine erzeugte Wärmemenge kann mit der Erfindung erheblich reduziert werden. Vorteilhafterweise kann mit der Erfindung eine Energieversorgungsvorrichtung bereitgestellt werden, die vor allem auch solche Werkzeugmaschine optimal mit elektrischer Energie versorgen kann, die hohe Anforderungen an Leistung und Entladestrom stellen. Mit anderen Worten kann mit der Erfindung eine Energieversorgungsvorrichtung für besonders leistungsstarke Werkzeugmaschine bereitgestellt werden, mit denen beispielsweise auf Baustellen schwere Bohr- oder Abbrucharbeiten verrichtet werden.

Der Begriff «Werkzeugmaschine» ist im Sinne der Erfindung als typisches Gerät zu verstehen, dass auf einer Baustelle, beispielsweise einer Hochbau-Baustelle und/oder einer Tiefbau-Baustelle, verwendet werden kann. Es kann sich um Bohrhämmer, Meißelgeräte, Kernbohrgerät, Winkel- oder Trennschleifer, Trenngeräte oder dergleichen handeln, ohne darauf beschränkt zu sein. Darüber hinaus können Hilfsgeräte, wie sie gelegentlich auf Baustellen verwendet werden, wie Lampen, Radios, Staubsauger, Meßgeräte, Bau-Roboter, Schubkarren, Transportgeräte, Vorschubvorrichtungen oder andere Hilfsgeräte «Werkzeugmaschine» im Sinne der Erfindung sein. Die Werkzeugmaschine kann insbesondere eine mobile Werkzeugmaschine sein, wobei die vorgeschlagene Energieversorgungsvorrichtung insbesondere auch in stationären Werkzeugmaschinen, wie ständergeführten Bohrgeräten oder Kreissägen, zum Einsatz kommen kann. Bevorzugt sind aber handgeführte Werkzeugmaschinen, die insbesondere akku- oder batteriebetrieben sind.

Es ist im Sinne der Erfindung bevorzugt, dass die mindestens eine Zelle eine Temperatur-Abkühl-Halbwertzeit kleiner als 12 Minuten aufweist, bevorzugt kleiner 10 Minuten, besonders bevorzugt kleiner 8 Minuten. Das bedeutet im Sinne der Erfindung bevorzugt, dass sich bei freier Konvektion eine Temperatur der mindestens einen Zelle in weniger als 12, 10 oder 8 min halbiert. Die Temperatur-Abkühl-Halbwertzeit wird vorzugsweise in einem Ruhezustand der Energieversorgungsvorrichtung ermittelt, d.h. wenn die Energieversorgungsvorrichtung nicht in Betrieb, d.h. mit einer Werkzeugmaschine verbunden vorliegt. Vor allem Energieversorgungsvorrichtungen mit Temperatur-Abkühl-Halbwertzeiten von kleiner als 8 min haben sich als besonders geeignet für den Einsatz bei leistungsstarken Werkzeugmaschinen gezeigt. Selbstverständlich kann die Temperatur-Abkühl-Halbwertzeit auch einen Wert von 8,5 Minuten, 9 Minuten 20 Sekunden oder von 11 Minuten 47 Sekunden aufweisen.

Durch die überraschend geringe Temperatur-Abkühl-Halbwertzeit der vorgeschlagenen Energieversorgungsvorrichtung verweilt die im Betrieb der Werkzeugmaschine oder bei ihrem Laden erzeugte Wärme nur für kurze Zeit innerhalb der mindestens einen Zelle. Auf diese Weise kann die Zelle besonders schnell wieder aufgeladen werden und steht zügig für einen erneuten Einsatz in der Werkzeugmaschine zur Verfügung. Vielmehr kann die thermische Belastung der Komponente der Energieversorgungsvorrichtung oder der Werkzeugmaschine mit der vorgeschlagenen Energieversorgungsvorrichtung erheblich reduziert werden. Dadurch kann die Energieversorgungsvorrichtung geschont und ihre Lebenszeit verlängert werden.

Es ist im Sinne der Erfindung bevorzugt, dass die mindestens eine Zelle in einem Batteriepack der Energieversorgungsvorrichtung angeordnet ist. In dem Batteriepack können vorzugsweise eine Reihe von Einzelzellen zusammengefasst werden und auf diese Weise optimal in die Energieversorgungsvorrichtung eingefügt werden. Beispielsweise können 5, 6 oder 10 Zellen einen Batteriepack bilden, wobei auch ganzzahlige Vielfache dieser Zahlen möglich sind. Beispielsweise kann die Energieversorgungsvorrichtung einzelne Zellstränge aufweisen, die beispielsweise 5, 6 oder 10 Zellen umfassen können. Eine Energieversorgungsvorrichtung mit beispielsweise drei Strängen à fünf Zellen kann beispielsweise 15 Einzelzellen umfassen.

Es ist im Sinne der Erfindung bevorzugt, dass die Energieversorgungsvorrichtung eine Kapazität von wenigstens 2,2 Ah, bevorzugt wenigstens 2,5 Ah aufweist. Tests haben gezeigt, dass die genannten Kapazitätswerte besonders gut für den Einsatz von leistungsstarken Werkzeugmaschinen im Baugewerbe geeignet sind und den dortigen Anforderungen an Verfügbarkeit von elektrischer Energie und möglicher Nutzungsdauer der Werkzeugmaschine besonders gut entsprechen.

Vorzugsweise ist die mindestens eine Zelle der Energieversorgungsvorrichtung dazu eingerichtet, einen Entladestrom über wenigstens 10 s von wenigstens 20 A abzugeben. Beispielsweise kann eine Zelle der Energieversorgungsvorrichtung dazu ausgebildet sein, einen Entladestrom über wenigstens 10 s von wenigstens 20 A, insbesondere wenigstens 25 A, bereitzustellen. Mit anderen Worten kann die mindestens eine Zelle einer Energieversorgungsvorrichtung dazu eingerichtet sein, einen Dauerstrom von wenigstens 20 A, insbesondere von wenigstens 25 A, bereitzustellen.

Gleichfalls ist es denkbar, dass Spitzenströme, insbesondere kurzzeitige Spitzenströme, zu einer starken Erwärmung der Energieversorgungsvorrichtung führen können. Daher ist eine Energieversorgungsvorrichtung mit einer leistungsstarken Kühlung, wie sie durch die vorliegend beschriebenen Maßnahmen erzielt werden kann, besonders vorteilhaft. Denkbar ist beispielsweise, dass die mindestens eine Zelle der Energieversorgungsvorrichtung über 1 Sekunde hinweg wenigstens 50 A bereitstellen kann. Mit anderen Worten ist es im Sinne der Erfindung bevorzugt, dass die mindestens eine Zelle der Energieversorgungsvorrichtung dazu eingerichtet ist, einen Entladestrom über wenigstens 1 s von wenigstens 50 A bereitzustellen. Werkzeugmaschinen können oftmals kurzzeitig hohe Leistungen benötigen. Eine Energieversorgungsvorrichtung, deren Zellen dazu in der Lage sind, einen derartigen Spitzenstrom und/oder einen derartigen Dauerstrom abzugeben, kann daher besonders geeignet für leistungsstarke Werkzeugmaschinen sein, wie sie auf Baustellen eingesetzt werden.

Es ist im Sinne der Erfindung bevorzugt, dass die mindestens eine Zelle einen Elektrolyten umfasst, wobei der Elektrolyt bei Raumtemperatur vorzugsweise in einem flüssigen Aggregatzustand vorliegt. Der Elektrolyt kann Lithium, Natrium und/oder Magnesium umfassen, ohne darauf beschränkt zu sein. Insbesondere kann der Elektrolyt Lithium-basiert sein. Alternativ oder ergänzend kann er auch Natrium-basiert sein. Denkbar ist auch, dass der Akkumulator Magnesium-basiert ist. Die elektrolyt-basierte Energieversorgungsvorrichtung kann eine Nennspannung von wenigstens 10 V, bevorzugt wenigstens 18 V, insbesondere von wenigstens 28 V, beispielsweise 36 V, aufweisen. Ganz besonders bevorzugt ist eine Nennspannung in einem Bereich von 18 bis 22 V, insbesondere in einem Bereich von 21 bis 22 V. Die mindestens eine Zelle der Energieversorgungsvorrichtung kann beispielsweise eine Spannung von 3,6 V aufweisen, ohne darauf beschränkt zu sein.

Es ist im Sinne der Erfindung bevorzugt, dass die Energieversorgungsvorrichtung beispielsweise mit einer Laderate von 1,5 C, bevorzugt 2 C und am meisten bevorzugt von 3 C geladen wird. Unter einer Laderate xC kann dabei die Stromstärke verstanden werden, die benötigt wird, um eine entladene Energieversorgungsvorrichtung in einem dem Zahlwert x der Laderate x C entsprechenden Bruchteil einer Stunde vollständig aufzuladen. Eine Laderate von 3 C ermöglicht beispielsweise ein vollständiges Aufladen des Akkumulators binnen 20 Minuten.

Es ist im Sinne der Erfindung bevorzugt, dass die mindestens Zelle der Energieversorgungsvorrichtung eine Oberfläche A und ein Volumen V aufweist, wobei ein Verhältnis A/V von Oberfläche zu Volumen größer ist als das Sechsfache, bevorzugt das Achtfache und besonders bevorzugt das Zehnfache des Kehrwerts der dritten Wurzel des Volumens.

Die Formulierung, dass die Oberfläche A der mindestens einen Zelle ist größer ist als beispielsweise das Achtfache der dritten Wurzel des Quadrats des Volumens V kann vorzugsweise auch durch die Formel ***A***>8****V*^(2/3)** zum Ausdruck gebracht werden. In einer anderen Schreibweise kann dieser Zusammenhang dadurch beschrieben werden, dass das Verhältnis A/V von Oberfläche zu Volumen größer ist als das Achtfache des Kehrwerts der dritten Wurzel des Volumens.

Dabei sind zur Prüfung, ob die obige Relation erfüllt ist, stets Werte in der gleichen Grundeinheit einzusetzen. Wenn beispielsweise ein Wert für die Oberfläche in m² in die obige Formel eingesetzt wird, so wird für das Volumen vorzugsweise ein Wert in der Einheit m³ eingesetzt. Wenn beispielsweise ein Wert für die Oberfläche in der Einheit cm² in die obige Formel eingesetzt wird, so wird für das Volumen vorzugsweise ein Wert in der Einheit cm³ eingesetzt. Wenn beispielsweise ein Wert für die Oberfläche in der Einheit mm² in die obige Formel eingesetzt wird, so wird für das Volumen vorzugsweise ein Wert in der Einheit mm³ eingesetzt.

Zellgeometrien, die beispielsweise die Relation von ***A***>8****V***^(**2**/**3**) erfüllen, weisen vorteilhafterweise ein besonders günstiges Verhältnis zwischen der für die Kühlwirkung maßgeblichen Außenfläche der Zelle zum Zellvolumen auf. Dabei haben die Erfinder erkannt, dass das Verhältnis von Oberfläche zu Volumen der mindestens einen Zelle der Energieversorgungsvorrichtung einen wichtigen Einfluss auf die Entwärmung der Energieversorgungsvorrichtung hat. Die verbesserte Kühlfähigkeit der vorgeschlagenen Energieversorgungsvorrichtung kann vorteilhafterweise durch eine Erhöhung der Zelloberfläche bei gleichbleibendem Volumen und geringem Innenwiderstand der mindestens einen Zelle erreicht werden. Es ist im Sinne der Erfindung bevorzugt, dass eine geringe Zelltemperatur bei gleichzeitig hoher Leistungsabgabe vorzugsweise dann ermöglicht werden kann, wenn der Innenwiderstand der Zelle reduziert wird. Die Reduzierung des Innenwiderstands der mindestens einen Zelle kann zu einer geringeren Wärmeentstehung führen. Darüber hinaus kann eine geringe Zelltemperatur durch die Verwendung von Zellen, bei denen die Oberfläche A von mindestens einer Zelle innerhalb der Energieversorgungsvorrichtung größer ist als das Sechsfache, bevorzugt das Achtfache und besonders bevorzugt das Zehnfache der dritten Wurzel des Quadrats des Volumens V der mindestens einen Zelle. Dadurch kann insbesondere die Wärmeabgabe an die Umgebung verbessert werden.

Es hat sich gezeigt, dass Energieversorgungsvorrichtungen, deren Zellen die genannte Relation erfüllen, deutlich besser gekühlt werden können als bisher bekannte Energieversorgungsvorrichtungen mit beispielsweise zylinderförmigen Zellen. Die obige Relation kann beispielsweise dadurch erfüllt werden, dass die Zellen der vorgeschlagenen Energieversorgungsvorrichtung zwar eine zylinderförmige Grundform aufweisen, aber zusätzliche Oberflächen vergrößernde Elemente auf ihrer Oberfläche angeordnet sind. Dabei kann es sich beispielsweise um Rippen, Zähne oder dergleichen handeln. Es können im Rahmen der Erfindung auch Zellen verwendet werden, die keine zylinderförmige oder zylindrische Grundform aufweisen, sondern vollkommen anders geformt sind. Beispielsweise können die Zellen der vorgeschlagenen Energieversorgungsvorrichtung eine im Wesentlichen quader- oder würfelförmige Grundform aufweisen. Der Begriff "im Wesentlichen" ist dabei für den Fachmann nicht unklar, weil der Fachmann weiß, dass im Kontext der vorliegenden Erfindung beispielsweise auch ein Quader mit Einbuchtungen oder abgerundeten Ecken und/oder Kanten unter den Begriff "im Wesentlichen quaderförmig" fallen soll.

Es ist im Sinne der Erfindung bevorzugt, dass die mindestens eine Zelle einen Zellkern aufweist, wobei kein Punkt innerhalb des Zellkerns mehr als 5 mm von einer Oberfläche der Energieversorgungsvorrichtung entfernt ist. Wenn die Energieversorgungsvorrichtung entladen wird, beispielsweise wenn sie mit einer Werkzeugmaschine verbunden ist und mit der Werkzeugmaschine gearbeitet wird, kann im Zellkern Wärme entstehen. Diese Wärme kann in dieser konkreten Ausgestaltung der Erfindung auf verhältnismäßig kurzem Wege bis zur Oberfläche der Zelle der Energieversorgungsvorrichtung transportiert werden. Von der Oberfläche kann die Wärme optimal abgeführt werden. Somit kann eine solche Energieversorgungsvorrichtung eine gute Kühlung, insbesondere eine vergleichsweise gute Selbstkühlung, aufweisen. Die Zeitdauer bis zum Erreichen der Grenztemperatur kann verlängert und/oder das Erreichen der Grenztemperatur vorteilhafterweise gänzlich vermieden werden. Als weiterer Vorteil der Erfindung kann Innerhalb des Zellkerns eine verhältnismäßig homogene Temperaturverteilung erreicht werden. Hierdurch kann sich eine gleichmäßige Alterung des Akkumulators ergeben. Dies wiederum kann die Lebensdauer der Energieversorgungsvorrichtung erhöhen.

Es ist im Sinne der Erfindung bevorzugt, dass die mindestens eine Zelle eine maximale Konstant-Strom-Abgabe von größer als 20 Ampère, bevorzugt größer als 30 Ampère, am meisten bevorzugt größer 40 Ampère aufweist. Die maximale Konstant-Strom-Abgabe ist die Menge an Strom einer Zelle oder einer Energieversorgungsvorrichtung, die entnommen werden kann, ohne dass die Zelle oder die Energieversorgungsvorrichtung an eine Temperatur-Obergrenze gelangt. Mögliche Temperatur-Obergrenze können in einem Bereich von 60 °C oder 70 °C liegen, ohne darauf beschränkt zu sein. Die Einheit der maximalen Konstant-Strom-Abgabe ist Ampère.

Bei allen Wertebereichen, die im Kontext der vorliegenden Erfindung genannt werden, sollen stets auch alle Zwischenwerte als offenbart gelten. Als Beispiel sollen bei der maximalen Konstant-Strom-Abgabe auch Werte zwischen 20 und 30 A als offenbart gelten, also zum Beispiel 21; 22,3; 24, 25,55 oder 27,06 Ampère usw. Darüber hinaus sollen auch Werte zwischen 30 und 40 A als offenbart gelten, also zum Beispiel 32; 33,3; 36, 38,55 oder 39,07 Ampère usw.

Es ist im Sinne der Erfindung bevorzugt, dass die Energieversorgungsvorrichtung eine Entlade-C-Rate von größer als 80 · t^(-0,45) aufweist, wobei der Buchstabe "t" für die Zeit in der Einheit Sekunden steht. Die C-Rate ermöglicht vorteilhafterweise eine Quantifizierung der Lade- und Entladeströme für Energieversorgungsvorrichtungen, wobei die hier verwendete Enlade-C-Rate insbesondere die Quantifizierung der Entladeströme von Energieversorgungsvorrichtungen ermöglicht. Mit der C-Rate können beispielsweise die maximal zulässigen Lade- und Entladeströme angegeben werden. Diese Lade- und Entladeströme hängen vorzugsweise von der Nennkapazität der Energieversorgungsvorrichtung ab. Die ungewöhnlich hohe Entlade-C-Rate von 80 · t^(-0,45) bedeutet vorteilhafterweise, dass mit der vorgeschlagenen Energieversorgungsvorrichtung besonders hohe Entladeströme erreicht werden können, die für den Betrieb von leistungsstarken Werkzeugmaschinen im Baugewerbe erforderlich sind. Beispielsweise können die Entladeströme in einem Bereich von größer als 40 Ampère, bevorzugt größer als 60 Ampère oder noch mehr bevorzugt größer als 80 Ampère liegen.

Es ist im Sinne der Erfindung bevorzugt, dass die Zelle einen Zelltemperaturgradienten von kleiner 10 Kelvin aufweist. Der Zelltemperaturgradient ist vorzugsweise ein Maß für Temperaturunterschiede innerhalb der mindestens einen Zelle der vorgeschlagenen Energieversorgungsvorrichtung, wobei es im Sinne der Erfindung bevorzugt ist, dass die Zelle eine möglichst gleichmäßige Temperaturverteilung aufweist, d.h. dass eine Temperatur in einem inneren Bereich der Zelle möglichst wenig abweicht von einer Temperatur, die im Bereich einer Mantel- oder Außenfläche der Zelle gemessen wird.

Weitere Vorteile ergeben sich aus der folgenden Figurenbeschreibung. Die Figuren, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

In den Figuren sind gleiche und gleichartige Komponenten mit gleichen Bezugszeichen beziffert.

Es zeigen:
- Fig. 1: schematische Schnittzeichnung durch eine bevorzugte Ausgestaltung der vorgeschlagenen Leiterplatte
- Fig. 2: schematische Seitenansicht einer bevorzugten Ausgestaltung der Energieversorgungsvorrichtung
- Fig. 3: schematische Seitenansicht einer bevorzugten Ausgestaltung und der Energieversorgungsvorrichtung

### Ausführungsbeispiele und Figurenbeschreibung:

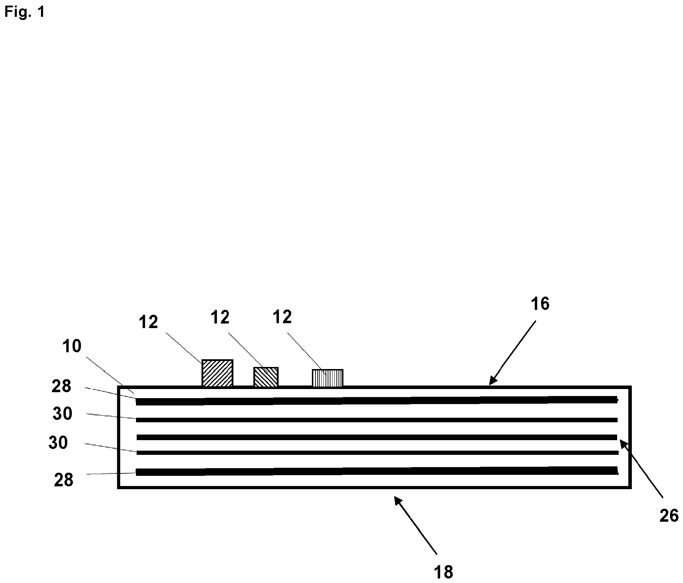

Figur 1 zeigt eine schematische Schnittzeichnung einer bevorzugten Ausführungsform der vorgeschlagenen Leiterplatte 10. Die Leiterplatte 10 hat eine Vorder- oder Oberseite 16, sowie eine Unter- oder Rückseite 18. Darüber hinaus kann die Leiterplatte 10 einzelne Lagen 26, 28, 30 umfassen, aus denen die Leiterplatte 10 aufgebaut ist. Die Lagen 26, 28, 30 können KupferBereiche aufweisen, die mit isolierenden Schichten voneinander getrennt vorliegen können. Auf der Vorderseite 16 (top) der Leiterplatte 10 ist ein elektronisches Bauteil 12 angeordnet, das vorzugsweise ein Leistungshalbleiter sein kann.

Die Leiterplatte 10 kann insbesondere innere Schichten 30 aufweisen, sowie äußere Schichten 28. Die inneren Schichten 30 können vorzugsweise eine geringere Stärke als die äußeren Schichten 28 aufweisen. Es sind insbesondere die äußeren Schichten 28, die innerhalb der Leiterplatte 10 zur Strom- und/oder Leistungsführung verwendet werden. Diejenigen der Lagen 28, 30, die die Ströme führen, werden im Sinne der Erfindung bevorzugt als «stromführende Lagen 26» bezeichnet. In Fig. 1 ist eine mittlere Lage mit dem Bezugszeichen 26 versehen, wobei diese Lage vorzugsweise eine stromführende Lage 26 ist. Sie stellt gleichzeitig auch eine innere Lage 30 im Sinne der Erfindung dar. Die inneren Schichten 30, die vorzugsweise eine geringere Stärke als die äußeren Lagen 28 aufweisen, können vorzugsweise zur Übertragung von Daten/oder Kommunikationssignalen verwendet werden.

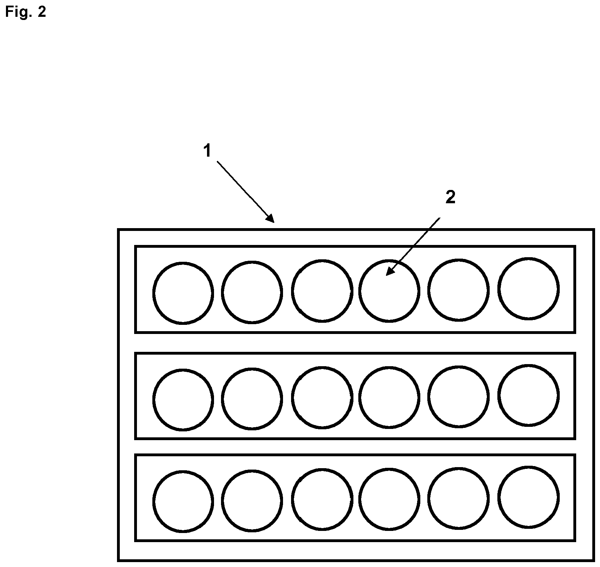

Figur 2 zeigt eine schematische Seitenansicht einer bevorzugten Ausgestaltung der Energieversorgungsvorrichtung 1. Die in Fig. 2 dargestellte Energieversorgungsvorrichtung 1 weist achtzehn Zellen 2 auf, wobei die achtzehn Zellen 2 in drei Strängen innerhalb der Energieversorgungsvorrichtung 1 angeordnet vorliegen. Die Zellen 2 werden insbesondere durch die Kreise symbolisiert, während die Stränge durch die länglichen Rechtecke symbolisiert werden, die die Kreise («Zellen 2») umgeben.

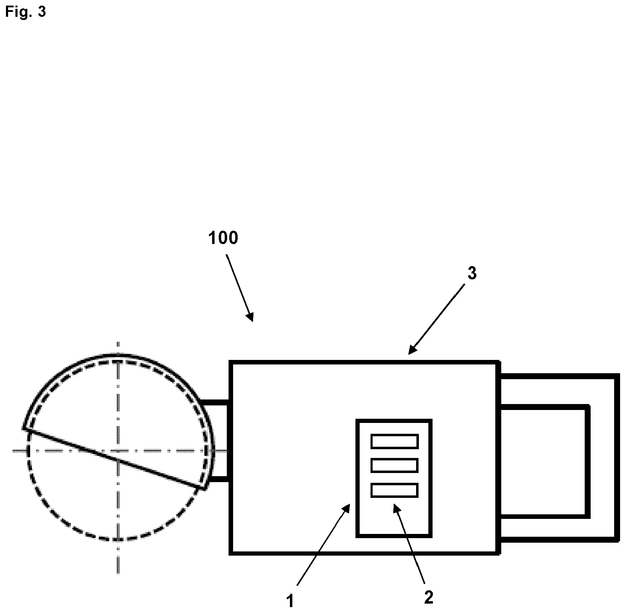

Fig. 3 zeigt eine schematische Ansicht einer Werkzeugmaschine 3 mit einer vorgeschlagenen Energieversorgungsvorrichtung 1. Bei der Werkzeugmaschine 3 kann es sich beispielsweise um einen Trennschleifer handeln, der als Werkzeug eine Trennscheibe aufweist. Die Werkzeugmaschine 3 kann einen Griff aufweisen, der beispielsweise als hinterer Handgriff ausgebildet ist. Darüber hinaus kann die Werkzeugmaschine 3 in an sich bekannter Weise Bedienelemente, wie Schalter oder Knöpfe, aufweisen. Außerdem kann die Werkzeugmaschine 3 einen Motor (nicht dargestellt) aufweisen, der einen Verbraucher darstellen und von der Energieversorgungsvorrichtung 1 mit elektrischer Energie versorgt werden kann. Es ist im Sinne der Erfindung bevorzugt, dass die Werkzeugmaschine 3 mit der Energieversorgungsvorrichtung 1 ein System 100 bildet.

### Bezugszeichenliste

- 1: Energieversorgungsvorrichtung
- 2: Zelle
- 3: Werkzeugmaschine
- 10: Leiterplatte
- 12: elektronisches Bauteil
- 16: Oberseite der Leiterplatte
- 18: Oberseite der Leiterplatte
- 26: stromführende Lage
- 28: äußere Lagen der Leiterplatte
- 30: innere Lagen der Leiterplatte
- 100: System

## Patentansprüche

1. Leiterplatte (10) zur Verwendung in einer Energieversorgungsvorrichtung (1) oder in einer Werkzeugmaschine (3),
**dadurch gekennzeichnet, dass**
die Leiterplatte (10) mindestens eine äußere Lage (28) und mindestens eine innere Lage (30) aufweist, wobei mindestens eine der Lagen (28, 30) ganz oder teilweise aus Kupfer gebildet ist.

2. Leiterplatte (10) nach Anspruch 1
**dadurch gekennzeichnet, dass**
die Leiterplatte (10) insgesamt mindestens vier Lagen (28, 30) umfasst, wobei mindestens eine der Lagen (28, 30) ganz oder teilweise aus Kupfer gebildet ist.

3. Leiterplatte (10) nach Anspruch 1 oder 2
**dadurch gekennzeichnet, dass**
die mindestens eine äußere Lage (28) eine Stärke von größer oder gleich 70 µm aufweist.

4. Leiterplatte (10) nach einem der vorhergehenden Ansprüche
**dadurch gekennzeichnet, dass**
die mindestens eine innere Lage (30) eine Stärke von kleiner oder gleich 70 µm aufweist.

5. Leiterplatte (10) nach einem der vorhergehenden Ansprüche
**dadurch gekennzeichnet, dass**
die Leiterplatte (10) mindestens eine stromführende Lage (26) aufweist, wobei eine Gesamtkupferstärke der mindestens einen stromführenden Lage in einem Bereich von größer als 130 µm liegt, bevorzugt in einem Bereich von größer als 150 µm und am meisten bevorzugt in einem Bereich von größer als 200 µm.

6. Leiterplatte (10) nach einem der vorhergehenden Ansprüche
**dadurch gekennzeichnet, dass**
eine Gesamtkupferstärke aller Lagen (26, 28, 30) in einem Bereich von größer als 210 µm liegt.

7. Leiterplatte (10) nach einem der vorhergehenden Ansprüche
**dadurch gekennzeichnet, dass**
eine Leistungsführung in der mindestens einen äußeren Lage (28) der Leiterplatte (10) erfolgt.

8. Leiterplatte (10) nach einem der vorhergehenden Ansprüche
**dadurch gekennzeichnet, dass**
die Leiterplatte (10) mindestens ein elektronisches Bauteil (12) aufweist.

9. System (100) umfassend eine Werkzeugmaschine (3) und eine Energieversorgungsvorrichtung (1)
**dadurch gekennzeichnet, dass**
die Werkzeugmaschine (3) und/oder die Energieversorgungsvorrichtung (1) eine Leiterplatte (10) nach einem der vorhergehenden Ansprüche aufweist.

10. Werkzeugmaschine (3)
**dadurch gekennzeichnet, dass**
die Werkzeugmaschine eine Leiterplatte (10) nach einem der Ansprüche 1 bis 8 aufweist.

11. Energieversorgungsvorrichtung (1)
**dadurch gekennzeichnet, dass**
die Energieversorgungsvorrichtung (1) eine Leiterplatte (10) nach einem der Ansprüche 1 bis 8 aufweist.

12. Energieversorgungsvorrichtung (1) nach Anspruch 11
**dadurch gekennzeichnet, dass**
die Energieversorgungsvorrichtung (1) mindestens eine Zelle (4) umfasst, wobei die mindestens eine Zelle (2) einen Innenwiderstand DCR_I von kleiner als 10 Milliohm aufweist.

13. Energieversorgungsvorrichtung (1) nach Anspruch 11 oder 12
**dadurch gekennzeichnet, dass**
die Energieversorgungsvorrichtung (1) mindestens eine Zelle (2) umfasst, wobei die mindestens Zelle (2) eine Oberfläche A und ein Volumen V aufweisen, wobei ein Verhältnis A/V von Oberfläche zu Volumen größer ist als das Sechsfache, bevorzugt das Achtfache und besonders bevorzugt das Zehnfache des Kehrwerts der dritten Wurzel des Volumens.

14. Energieversorgungsvorrichtung (1) nach einem der Ansprüche 11 bis 13
**dadurch gekennzeichnet, dass**
die Energieversorgungsvorrichtung (1) mindestens eine Zelle (2) umfasst, wobei ein Verhältnis eines Widerstands der mindestens einen Zelle (2) zu einer Oberfläche A der mindestens einen Zelle (2) kleiner als 0,2 Milliohm/cm² ist, bevorzugt kleiner als 0,1 Milliohm/cm², am meisten bevorzugt kleiner als 0,05 Milliohm/cm².

15. Energieversorgungsvorrichtung (1) nach einem der Ansprüche 11 bis 14
**dadurch gekennzeichnet, dass**
die Energieversorgungsvorrichtung (1) eine Kapazität von wenigstens 2,2 Ah, bevorzugt wenigstens 2,5 Ah aufweist.
